(19) Europäisches Patentamt / European Patent Office / Office européen des brevets

(11) **EP 3 489 696 A1**

(12) **EUROPÄISCHE PATENTANMELDUNG**

(43) Veröffentlichungstag:
**29.05.2019 Patentblatt 2019/22**

(51) Int Cl.:
***G01R 15/18*** *(2006.01)*

(21) Anmeldenummer: **18203713.5**

(22) Anmeldetag: **31.10.2018**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(30) Priorität: **27.11.2017 DE 102017221173**

(71) Anmelder: **Siemens Aktiengesellschaft
80333 München (DE)**

(72) Erfinder:
• **Ringer, Florian
92249 Vilseck (DE)**
• **Hertz, Dirk
92260 Fichtenhof (DE)**

(54) **STROMMESSVORRICHTUNG, BAUREIHE VON STROMMESSVORRICHTUNGEN UND VERFAHREN ZUR STROMMESSUNG**

(57) Die Erfindung betrifft eine Strommessvorrichtung (100), aufweisend eine Baugruppe (2) mit zwei oder mehr Bürden (61, 62, 63) in Reihenschaltung (6) und ein Stromwandlermodul (4, 4a, 4b, 4c) mit einer Sekundärspule (20). Die Reihenschaltung (6) weist dabei drei oder mehr Kontakte (18a, 18b, 18c, 18d) auf, so dass durch die Anschlusskombinationen der Sekundärspule (20) an jeweils zwei der drei oder mehr Kontakte (18a, 18b, 18c, 18d) verschiedene Gruppen von ein oder mehr Bürden (61, 62, 63) mit der Sekundärspule (20) zu einem Stromkreis geschaltet werden können. Durch den so gebildeten Stromkreis kann ein durch einen zu messenden Primärstrom in der Sekundärspule (20) induzierter Sekundärstrom (22) fließen.

FIG 4

EP 3 489 696 A1

**Beschreibung**

Die Erfindung betrifft eine Strommessvorrichtung, eine Baureihe von Strommessvorrichtungen und ein Verfahren zur Strommessung.

Stromwandler sind bekannt, siehe z. B. DE102006059384A1 (Siemens AG) 26.06.2008 und WO2012/022377A1 (Siemens AG) 23.02.2012. Die Erfassung unterschiedlicher Betriebszustände mit teilweise sehr großen, teilweise aber auch sehr niedrigen Strömen stellt hohe Anforderungen an Stromwandler, die entsprechend zur Messung hoher und niedriger Ströme geeignet sein müssen. Stromwandler, welche üblicherweise auf Basis der elektrischen Induktion funktionieren, dienen primärseitig zur Erfassung eines zu messenden Primärstromes, durch den auf der Sekundärseite des Stromwandlers ein hinsichtlich seines Pegels reduzierter Sekundärstrom hervorgerufen wird. Damit dient der Stromwandler einerseits der Potenzialtrennung und andererseits der Reduzierung des Signalpegels. Die Höhe des Sekundärstroms ist dabei einerseits von dem Verhältnis der Windungszahlen der Wicklungen auf der Primärseite und der Sekundärseite des Stromwandlers und andererseits von einem Bürdenwiderstand abhängig, der ausgangsseitig mit der Sekundärspule verbunden ist und über den der Sekundärstrom fließt.

Viele in Drehstromsystemen eingesetzte Gerätereihen decken einen sehr großen Lastbereich, genauer: Strombereich, ab. Um die gestellten Anforderungen an die Genauigkeit der gemessenen Stromwerte über den gesamten Strombereich gewährleisten zu können, müssen in den Gerätereihen je nach Strombereich verschiedene Stromwandler eingesetzt werden. Meist reicht es aber nicht aus, nur die Windungszahl im Sekundärkreis der Stromwandler anzupassen, sondern es muss auch die Bürde angepasst werden.

DE3541274A1 (Brown, Boveri & Cie AG) 27.05.1987 beschreibt eine Messeinrichtung zur Erfassung des Stromistwertes bei einem Stromrichter, mit einem Stromwandler und einer nachgeschalteten Bürde. Dabei ist die Bürde als variabel auf unterschiedliche ohmsche Widerstandswerte einstellbares Bürdenschaltwerk ausgebildet, wobei die Einstellung der Bürde in Abhängigkeit der an den Stromrichter geschalteten Last erfolgt. Zu diesem Zweck stellt ein Mikrorechner in Abhängigkeit eines eingegebenen Lasttyps eines Stromrichters durch Öffnen und Schließen der Schalter eines Bürdenschaltwerkes eine gemäß einer eingespeicherten Kombinationstabelle erforderliche Bürde ein.

Ein mehrere parallel geschaltete Bürden aufweisendes Bürdenschaltwerk, basierend auf einer fehlerfreien Ansteuerung einer Vielzahl von Schaltern durch einen Mikrorechner gemäß einer eingespeicherten Kombinationstabelle, ist aber relativ aufwändig.

Der vorliegenden Erfindung liegt die Aufgabe zugrunde, einen Stromwandler bereitzustellen, der auf einfache Weise an unterschiedliche Lastbereiche adaptierbar ist.

Die Aufgabe wird erfindungsgemäß gelöst durch eine Strommessvorrichtung, aufweisend eine Baugruppe mit zwei oder mehr Bürden in Reihenschaltung und ein Stromwandlermodul mit einer Sekundärspule. Dabei weist die Reihenschaltung drei oder mehr Kontakte auf, so dass durch die möglichen Anschlusskombinationen der Sekundärspule an jeweils zwei der drei oder mehr Kontakte verschiedene Gruppen von ein oder mehr Bürden mit der Sekundärspule zu einem Stromkreis geschaltet werden können, durch welchen ein durch einen zu messenden Primärstrom in der Sekundärspule induzierter Sekundärstrom fließen kann. Die Aufgabe wird ferner gelöst durch ein Verfahren zur Strommessung, mit folgenden Schritten: Bereitstellen einer Baugruppe mit zwei oder mehr Bürden in Reihenschaltung, wobei die Reihenschaltung drei oder mehr Kontakte umfasst; Bereitstellen eines Stromwandlermoduls mit einer Sekundärspule; Auswählen einer der möglichen Anschlusskombinationen, bei denen die Sekundärspule mit jeweils zwei der drei oder mehr Kontakte so verbunden ist, dass mindestens eine der Bürden mit der Sekundärspule einen Stromkreis bildet; Verbinden der Sekundärspule mit zwei der drei oder mehr Kontakte gemäß der gewählten Anschlusskombination; Positionieren der Sekundärspule so, dass durch einen zu messenden Primärstrom in der Sekundärspule induzierter Sekundärstrom durch den Stromkreis fließt; Abgreifen einer Spannung, welche über mindestens zwei der zwei oder mehr in Reihe geschalteten Bürden abfällt; und Berechnen eines Stromwerts des Primärstroms aus der gemessenen Spannung.

Die Reihenschaltung weist drei oder mehr Kontakte auf, so dass mehrere Anschlusskombinationen der Sekundärspule an jeweils zwei der drei oder mehr Kontakte möglich sind. Mit jeder der Anschlusskombinationen werden verschiedene Gruppen von ein oder mehr Bürden mit der Sekundärspule zu einem Stromkreis geschaltet. Auf diese Weise kann man die in den Stromkreis geschalteten Widerstände so in Gruppen zusammenschalten, dass die Gesamtwiderstandswerte der verschiedenen Gruppen an unterschiedliche Messsituationen angepasst sind.

Vorzugsweise ist die Strommessvorrichtung ein Stromwandler, z.B. ein Ringkern-Stromwandler. Die Strommessvorrichtung kann in Drehstromsystemen zur Messung der Phasenströme eingesetzt werden, z.B. in einem Sanftstarter. Die Strommessvorrichtung funktioniert wie ein spezieller Transformator; sie hat eine Sekundärspule mit einer oder mehreren Sekundärwindungen, welche in der Nähe einer Primärspule mit nur einer oder wenigen Primärwindungen, die vom zu messenden Strom durchflossen wird, angeordnet wird. Dabei kann die Primärspule durch einen durch den Stromwandler geführten Stromleiter gebildet sein, was einer Spule mit einer einzigen Windung entspricht. Der zu messende Primärstrom wird proportional um das Verhältnis Primärwindungszahl zur Sekundärwindungszahl verringert. Über den an die Sekundärspule angeschlossenen, der Strommessung dienenden Widerstand fließt der Sekundärstrom des Stromwandlers. Dieser Widerstand wird als Bürde, Wandlerbürde oder Bürdenwiderstand bezeichnet. Die an der Bürde anliegende Spannung kann mit verfügbaren Messinstrumenten oder elektronischen Schaltungen weiterverarbeitet werden.

Die Spannung an der Bürde kann mit einer Steuerelektronik gemessen und daraus in Verbindung aus den bekannten Größen Bürdenwiderstand und Anzahl der Primär- und Sekundärwicklungen der Primärstrom berechnet werden.

Der Erfindung liegt die Erkenntnis zugrunde, dass eine als Stromwandler dienende Strommessvorrichtung in einfacher Weise modular aufgebaut werden kann. Durch eine Reihenschaltung aus mehreren Bürden ist es möglich, verschiedene Bürdenwiderstände mit einer identischen Bestückung der Baugruppe zu nutzen.

Das der Erfindung zugrunde liegende Funktionsprinzip ist wie folgt: Das Stromwandlermodul wird, vorzugsweise über einen Steckverbinder, an die Baugruppe, z.B. in Form einer Steuerplatine, angeschlossen. Der in der Sekundärspule induzierte Wandlerstrom fließt über die eine oder mehreren Bürden. Die über alle Bürden abfallende Spannung wird gemessen, vorzugsweise mithilfe einer Messwerterfassungseinheit. Je nachdem, wie das Stromwandlermodul mit der Baugruppe verbunden wird, z.B. an welchen Steckerpins die Sekundärspule des Stromwandlermoduls angeschlossen ist, fließt der Wandlerstrom über verschiedene Bürden.

Durch den hohen Innenwiderstand eines Spannungs-Messgeräts zur Messung der über alle Bürden abfallenden Spannung ist das Verhältnis des Bürdenwiderstands der in den Stromkreis mit der Sekundärspule geschalteten Bürden der Reihenschaltung zu dem Innenwiderstand des Spannungs-Messgeräts der Messwerterfassungseinheit nahezu null; somit ist der Spannungsabfall an den nicht in den Stromkreis mit der Sekundärspule geschalteten Bürden der Reihenschaltung, die nicht vom im Stromkreis fließenden Sekundärstrom bestromt werden, vernachlässigbar. Die von der Messwerterfassungseinheit gemessene Spannung entspricht also im Wesentlichen der Spannung an den in den Stromkreis mit der Sekundärspule geschalteten Bürden.

Die vorliegende Erfindung schafft nun eine Möglichkeit, eine Baureihe mit einer geringeren Zahl von Bauteilen innerhalb der Baureihe zu schaffen. Bisher wurden in einer Baureihe Baugruppen mit unterschiedlichen Bürden bestückt; es gab also verschiedene Varianten von Baugruppen innerhalb einer Baureihe. Mit der vorliegenden Erfindung ist es nun möglich, eine Baureihe mit einer einzigen Variante einer Baugruppe zu schaffen.

Die Bestückvarianz fällt weg, da die Bestückung der Baugruppe immer identisch ist. Dadurch entstehen geringere Kosten durch höhere Stückzahlen pro Variante, eine weniger umfangreiche Lagerhaltung und weniger Umrüstzeit und -kosten in der Bestück-Linie, weniger Bereitstellungsflächen in der Fertigung, einem geringeren Testaufwand und einer gesunkenen Zahl von Ersatzteilvarianten. Des Weiteren sinkt die Vertauschgefahr bei der Gerätemontage, d.h. es wird das Risiko gemindert, dass bei der Gerätemontage falsche Varianten der Baugruppe verbaut werden.

Vorteilhafte Ausgestaltungen und Weiterbildungen der Erfindung sind in den abhängigen Ansprüchen angegeben. Dabei kann das erfindungsgemäße Verfahren auch entsprechend den abhängigen Vorrichtungsansprüchen weitergebildet sein, und umgekehrt.

Gemäß einer bevorzugten Ausgestaltung der Erfindung umfasst die Strommessvorrichtung eine Messwerterfassungseinheit mit Messkontakten zum Abgreifen einer über mindestens zwei der zwei oder mehr Bürden abfallenden Spannung. Die Messwerterfassungseinheit kann aufgrund identischer Gerätefunktionen über eine gesamte Baureihe von Strommessvorrichtungen gleich sein. Die Messwerterfassungseinheit umfasst vorzugsweise eine Auswerteelektronik, welche die gemessenen Messwerte auswerten und weiterleiten kann, z.B. an eine Speichereinheit und/oder an ein HMI (= Human Machine Interface).

Gemäß einer bevorzugten Ausgestaltung der Erfindung umfasst die Strommessvorrichtung einen mehrere Pole aufweisenden Steckverbinder zum Verbinden des Stromwandlermoduls mit der Baugruppe. Durch die Verwendung einer mehrpoligen Steckverbindung in Kombination mit mehreren Bürdenwiderständen in Reihe ist es möglich, trotz einer identischen Bestückung der Baugruppe zur Spannungsmessung verschiedene Bürdenwiderstände zu nutzen, d.h. in den vom Sekundärstrom, auch als Wandlerstrom bezeichnet, durchflossenen Stromkreis zu schalten.

Das Volumen des Stromwandlermoduls ergibt sich vor allem aus dem zu messenden Primärstrom. Für Gerätebaureihen, die auch für große Primärströme geeignet sind, kann das Stromwandlermodul deshalb nicht in die Baugruppe, in welchem vorzugsweise das Messwerterfassungseinheit integriert ist, integriert werden. Die Sekundärspule des Stromwandlermoduls wird in dem Fall über einen Steckverbinder mit der Baugruppe, vorzugsweise umfassend eine Messwerterfassungseinheit und die Bürden und/oder eine Steuerelektronik, verbunden.

Gemäß einer bevorzugten Ausgestaltung der Erfindung sind die zwei oder mehr in Reihe geschalteten Bürden jeweils mit zwei Polen eines am der Baugruppe angeordneten Teils des Steckverbinders elektrisch leitend verbunden sind. Durch die Verwendung einer mehrpoligen Steckverbindung und eine unterschiedliche Stecker-Pin-Belegung bei unterschiedlichen Stromwandlermodulen ist es möglich, verschiedene Bürdenwiderstände mit einer identischen Bestückung der Baugruppe zu nutzen.

Gemäß einer bevorzugten Ausgestaltung der Erfindung ist die Sekundärspule des Stromwandlermoduls mit zwei Polen eines am Stromwandlermodul angeordneten Teils des mehrpoligen Steckverbinders elektrisch leitend verbunden. Durch die Verwendung einer mehrpoligen Steckverbindung und eine unterschiedliche Stecker-Pin-Belegung bei unterschiedlichen Stromwandlermodulen ist es möglich, verschiedene Bürdenwiderstände mit einer identischen Bestückung der Baugruppe zu nutzen.

Das an der Baugruppe angeordnete Teil des Steckverbinders kann als ein männliches Steckerteil, z.B. ein Stecker oder ein Einbaustecker, oder als ein weibliches Steckerteil, z.B. eine Kupplung oder eine Buchse, ausgebildet sein. Das am Stromwandlermodul angeordnete Teil des Steckverbinders ist korrespondierend zu dem an der Baugruppe angeordneten Teil des Steckverbinders ausgebildet.

Gemäß einer bevorzugten Ausgestaltung der Erfindung weist die Reihenschaltung zwei oder mehr Paare von Bürden mit gleichem elektrischen Widerstand auf, welche bezüglich eines Symmetriepunkts der Reihenschaltung symmetrisch angeordnet sind. Da aufgrund des zu messenden Wechselstromes negative Spannungen bzw. Amplituden gemessen werden müssen, muss die Spannung des Symmetriepunkts (= Bezugspunkt) für die Bürden zwischen Versorgungsspannung und Masse der Messwerterfassungseinheit, die vorzugsweise eine Auswerteelektronik aufweist, liegen. Die differenzielle Auswertung hat zwei Vorteile: Erstens haben so Spannungsschwankungen des Symmetriepunktes keinen Einfluss auf die Messgenauigkeit, da bei der differenziellen Auswertung beide Spannungen bezogen auf die Masse der Auswerteeinheit subtrahiert werden. Außerdem entspricht die maximale Amplitude des Differenzsignals dem doppelten Wert der Amplitude eines Einzelsignals. Somit verdoppelt sich die Auflösung der Strommessung; die Genauigkeit wird dadurch besser.

Eine weitere bevorzugten Ausgestaltung der Erfindung ist eine Baureihe von Strommessvorrichtungen, wie sie oben beschrieben sind, wobei die Baugruppe mit zwei oder mehr unterschiedlichen Stromwandlermodulen verbindbar ist, und wobei zwei Strommessvorrichtungen der Baureihe, jeweils die Baugruppe und ein unterschiedliches Stromwandlermodul aufweisend, sich in mindestens einer Bürde unterscheiden, die mit der Sekundärspule zum Stromkreis geschaltet ist.

Gemäß einer bevorzugten Ausgestaltung der Erfindung Im Folgenden wird die Erfindung anhand mehrerer Ausführungsbeispiele unter Zuhilfenahme der beiliegenden Zeichnung erläutert. Es zeigt

Fig. 1     eine erste Variante einer Strommessvorrichtung;

Fig. 2     eine andere Variante einer Strommessvorrichtung;

Fig. 3     eine weitere Variante einer Strommessvorrichtung;

Fig. 4     eine Baureihe von Strommessvorrichtungen;

Fig. 5     eine erste Variante einer Strommessvorrichtung mit symmetrisch angeordneten Bürden;

Fig. 6     eine andere Variante einer Strommessvorrichtung mit symmetrisch angeordneten Bürden; und

Fig. 7     eine Variante einer Strommessvorrichtung mit einer erweiterten Anzahl von Bürden.

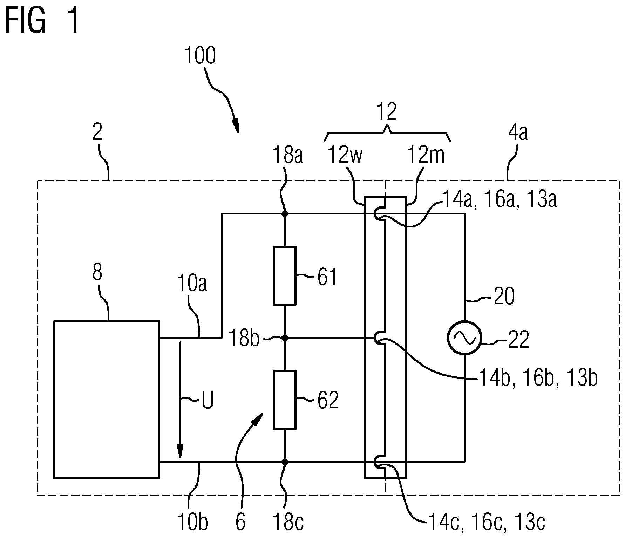

Fig. 1 bis 3 zeigen drei unterschiedliche Anschlusskombinationen einer Sekundärspule 20 und einer Reihenschaltung 6 von Bürden 61, 62.

Fig. 1 zeigt eine erste Ausgestaltung einer erfindungsgemäßen Strommessvorrichtung 100. Die Strommessvorrichtung 100 weist eine Baugruppe 2 mit zwei Bürden 61, 62 in Reihenschaltung 6 auf. Die Reihenschaltung 6 umfasst eine erste Bürde 61 zwischen einer ersten Kontaktstelle 18a und einer zweiten Kontaktstelle 18b sowie eine zweite Bürde 62 zwischen der zweiten Kontaktstelle 18b und einer dritten Kontaktstelle 18c. Die Strommessvorrichtung 100 weist ferner ein Stromwandlermodul 4a mit einer Sekundärspule 20 auf. Die Begriffe Kontakt und Kontaktstelle sind in der Beschreibung synonym benutzt.

Die Strommessvorrichtung 100 weist außerdem einen drei Pole 13a, 13b, 13c aufweisenden Steckverbinder 12 auf, mithilfe dessen das Stromwandlermodul 4a mit der Baugruppe 2 in einem Aufsteckvorgang lösbar verbunden ist. Die Pole 13a, 13b, 13c umfassen jeweils einen Kontaktstift 14a, 14b, 14c an einem männliche Teil 12m des Steckverbinders 12 und eine Kontaktöffnung 16a, 16b, 16c an einem weiblichen Teil 12w des Steckverbinders 12. Die drei Pole 13a, 13b, 13c umfassen zwei außenliegende Pole 13a, 13c und einen auf dem Steckverbinder 12 zwischen den zwei außenliegenden Polen 13a, 13c angeordneten mittleren Pol 13b.

Dabei ist die Sekundärspule 20 des Stromwandlermoduls 4a mit den Kontaktstiften 14a, 14c der zwei außen liegenden Pole 13a, 13c des Steckverbinders 12 elektrisch leitend verbunden. Die drei Kontaktstellen 18a, 18b und 18c der Reihenschaltung 6 sind jeweils mit einer Kontaktöffnung 16a, 16b, 16c der drei Pole 13a, 13b, 13c des Steckverbinders 12 elektrisch leitend verbunden. Dabei ist die erste Kontaktstelle 18a mit einer Kontaktöffnung 16a des ersten außenliegenden Pols 13a, die zweite Kontaktstelle 18b mit der Kontaktöffnung 16b des mittleren Pols 13b und die dritte Kontaktstelle 18c mit der Kontaktöffnung 16c des zweiten außenliegenden Pols 13c elektrisch verbunden. Durch das Verbinden des männlichen Teils 12m des Steckverbinders 12 mit dem weiblichen Teil 12w des Steckverbinders 12 in einem Aufsteckvorgang ist die Sekundärspule 20 mit der die zwei Bürden 61, 62 umfassenden Reihenschaltung 6 elektrisch verbunden, so dass die Sekundärspule 20 und die die zwei Bürden 61, 62 der Reihenschaltung 6 umfassende Gruppe von Bürden einen Stromkreis bilden. Es wird somit eine erste Anschlusskombination von Sekundärspule 20 und Reihenschaltung 6 realisiert.

Somit kann ein durch einen zu messenden Primärstrom in der Sekundärspule 20 induzierter Sekundärstrom 22 durch diesen Stromkreis fließen. Damit in der Sekundärspule 20 ein Sekundärstrom 22 durch einen Primärstrom induziert werden kann, muss die Sekundärspule 20 in der räumlichen Nähe einer den Primärstrom leitenden Primärspule positioniert werden.

Eine über den zwei Bürden 61, 62 des Stromkreises abfallende Spannung U, die sogenannte Bürdenspannung, wird abgegriffen, indem die erste Kontaktstelle 18a über einen ersten Messkontakt 10a mit einem ersten Eingang einer Messwerterfassungseinheit 8 und die dritte Kontaktstelle 18c über einen zweiten Messkontakt 10b mit einem zweiten Eingang einer Messwerterfassungseinheit 8 verbunden wird. Dabei kann der Spannungswert U einem Spannungs-Messgerät der Messwerterfassungseinheit 8 zugeführt und daraus der Stromwert I_1 des Primärstroms bestimmt werden. Zwischen der Bürdenspannung U, dem Stromwert I_1 des Primärstroms, dem elektrischen Widerstand R_2 der Bürden-Reihenschaltung 61, 62 und den Windungszahlen n_1 bzw. n_2 der Primärspule bzw. der Sekundärspule 20 besteht folgender Zusammenhang:

$$U = I\_1 \cdot (n\_1 \; / \; n\_2) \cdot R\_2$$

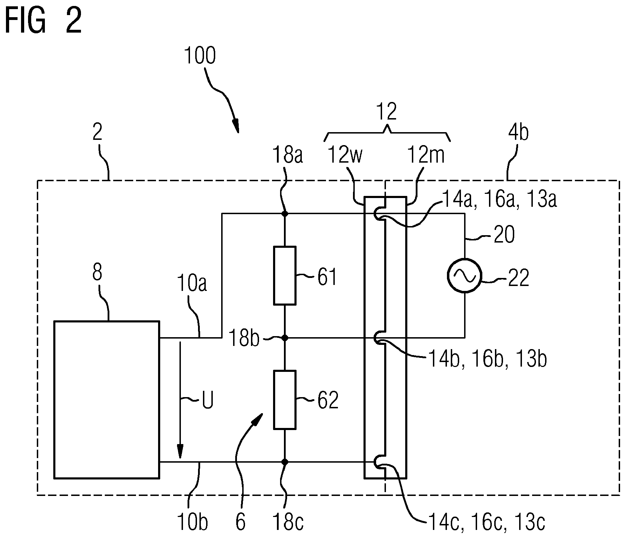

Fig. 2 zeigt eine weitere Ausgestaltung einer erfindungsgemäßen Strommessvorrichtung 100, umfassend eine Baugruppe 2, ein Stromwandlermodul 4b und einen drei Pole 13a, 13b, 13c aufweisenden Steckverbinder 12. Die in Fig. 2 gezeigte Baugruppe 2 ist identisch zu der in Fig. 1 dargestellten Baugruppe 2 ausgebildet; daher wird bezüglich der in Fig. 2 gezeigten Baugruppe 2 auf die Beschreibung der Baugruppe 2 in Fig. 1 verwiesen. Das gleiche gilt bezüglich des an der Baugruppe 2 angeordneten weiblichen Teils 12w des Steckverbinders 12.

Die in Fig. 2 gezeigte Strommessvorrichtung 100 unterscheidet sich von der in Fig. 1 gezeigten Strommessvorrichtung 100 in dem Stromwandlermodul 4b und in dem am Stromwandlermodul 4b angeordneten männlichen Teil 12m des Steckverbinders 12: Dabei ist die Sekundärspule 20 des Stromwandlermoduls 4b mit den Kontaktstiften 14a, 14b eines ersten außen liegenden Pols 13a und des mittleren Pols 13b des Steckverbinders 12 elektrisch leitend verbunden.

Durch das Verbinden des männlichen Teils 12m des Steckverbinders 12 mit dem weiblichen Teil 12w des Steckverbinders 12 ist die Sekundärspule 20 mit der ersten Bürde 61 der die zwei Bürden 61, 62 umfassenden Reihenschaltung 6 so elektrisch verbunden, dass die Sekundärspule 20 und die zwischen der ersten Kontaktstelle 18a und der zweiten Kontaktstelle 18b angeordnete erste Bürde 61 einen Stromkreis bilden. Es wird somit eine zweite Anschlusskombination von Sekundärspule 20 und Reihenschaltung 6 realisiert.

Somit kann ein durch einen zu messenden Primärstrom in der Sekundärspule 20 induzierter Sekundärstrom 22 durch diesen Stromkreis fließen. Damit in der Sekundärspule 20 ein Sekundärstrom 22 durch einen Primärstrom induziert werden kann, muss die Sekundärspule 20 in der räumlichen Nähe einer den Primärstrom leitenden Primärspule positioniert werden.

Eine über der ersten Bürde 61 des Stromkreises abfallende Spannung U, die sogenannte Bürdenspannung, wird abgegriffen, indem die erste Kontaktstelle 18a mit einem ersten Eingang einer Messwerterfassungseinheit 8 und die dritte Kontaktstelle 18c mit einem zweiten Eingang einer Messwerterfassungseinheit 8 verbunden wird. Dabei kann der Spannungswert U einem Spannungs-Messgerät der Messwerterfassungseinheit 8 zugeführt und daraus der Stromwert I_1 des Primärstroms bestimmt werden.

Spannungs-Messgeräte haben einen besonders hohen Innenwiderstand. Hierdurch wird garantiert, dass durch die Spannungs-Messgeräte kein Strom fließt, welcher die Eigenschaften der zu messenden Schaltung und somit die Messung beeinflussen würde. Durch den hohen Innenwiderstand des Spannungs-Messgeräts ist das Verhältnis von Bürdenwiderstand der ersten Bürde 61 zu dem Innenwiderstand des Spannungs-Messgeräts der Messwerterfassungseinheit 8 nahezu null; somit ist der Spannungsabfall an der zweiten Bürde 62 der Reihenschaltung 6, die nicht vom im Stromkreis fließenden Sekundärstrom 22 bestromt wird, vernachlässigbar. Die von der Messwerterfassungseinheit 8 gemessene Spannung U entspricht also der Spannung an der genutzten ersten Bürde 61.

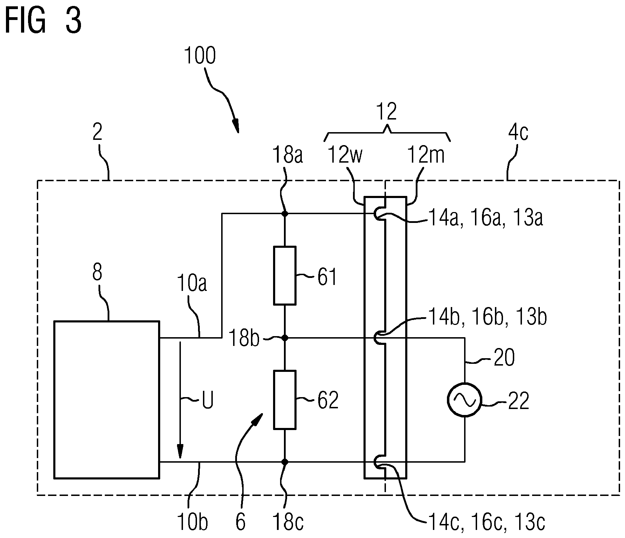

Fig. 3 zeigt eine weitere Ausgestaltung einer erfindungsgemäßen Strommessvorrichtung 100, umfassend eine Baugruppe 2, ein Stromwandlermodul 4c und einen drei Pole 13a, 13b, 13c aufweisenden Steckverbinder 12. Die in Fig. 3 gezeigte Baugruppe 2 ist identisch zu der in Fig. 1 dargestellten Baugruppe 2 ausgebildet; daher wird bezüglich der in Fig. 3 gezeigten Baugruppe 2 auf die Beschreibung der Baugruppe 2 zu Fig. 1 verwiesen. Das gleiche gilt bezüglich des an der Baugruppe 2 angeordneten weiblichen Teils 12w des Steckverbinders 12.

Die in Fig. 3 gezeigte Strommessvorrichtung 100 unterscheidet sich von der in Fig. 1 gezeigten Strommessvorrichtung 100 in dem Stromwandlermodul 4c und in dem am Stromwandlermodul 4c angeordneten männlichen Teil 12m des Steckverbinders 12: Dabei ist die Sekundärspule 20 des Stromwandlermoduls 4c mit den Kontaktstiften 14b, 14c des mittleren Pols 13b und eines zweiten außen liegenden Pols 13c des Steckverbinders 12 elektrisch leitend verbunden.

Durch das Verbinden des männlichen Teils 12m des Steckverbinders 12 mit dem weiblichen Teil 12w des Steckverbinders 12 ist die Sekundärspule 20 mit der zweiten Bürde 62 der die zwei Bürden 61, 62 umfassenden Reihenschaltung 6 so elektrisch verbunden, dass die Sekundärspule 20 und die zwischen der zweiten Kontaktstelle 18b und der dritten Kontaktstelle 18c angeordnete zweite Bürde 62 einen Stromkreis bilden. Es wird somit eine dritte Anschlusskombination von Sekundärspule 20 und Reihenschaltung 6 realisiert.

Somit kann ein durch einen zu messenden Primärstrom in der Sekundärspule 20 induzierter Sekundärstrom 22 durch diesen Stromkreis fließen. Damit in der Sekundärspule 20 ein Sekundärstrom 22 durch einen Primärstrom induziert werden kann, muss die Sekundärspule 20 in der räumlichen Nähe einer den Primärstrom leitenden Primärspule positioniert werden.

Eine über der zweiten Bürde 62 des Stromkreises abfallende Spannung U, die sogenannte Bürdenspannung, wird abgegriffen, indem die erste Kontaktstelle 18a mit einem ersten Eingang einer Messwerterfassungseinheit 8 und die dritte Kontaktstelle 18c mit einem zweiten Eingang einer Messwerterfassungseinheit 8 verbunden wird. Dabei kann der Spannungswert U einem Spannungs-Messgerät der Messwerterfassungseinheit 8 zugeführt und daraus der Stromwert I_1 des Primärstroms bestimmt werden.

Spannungs-Messgeräte haben einen besonders hohen Innenwiderstand. Hierdurch wird garantiert, dass durch die Spannungs-Messgeräte kein Strom fließt, welcher die Eigenschaften der zu messenden Schaltung und somit die Messung beeinflussen würde. Durch den hohen Innenwiderstand des Spannungs-Messgeräts ist das Verhältnis von Bürdenwiderstand der zweiten Bürde 62 zu dem Innenwiderstand des Spannungs-Messgeräts der Messwerterfassungseinheit 8 nahezu null; somit ist der Spannungsabfall an der ersten Bürde 61 der Reihenschaltung 6, die nicht vom im Stromkreis fließenden Sekundärstrom 22 bestromt wird, vernachlässigbar. Die von der Messwerterfassungseinheit 8 gemessene Spannung U entspricht also der Spannung an der genutzten zweiten Bürde 62.

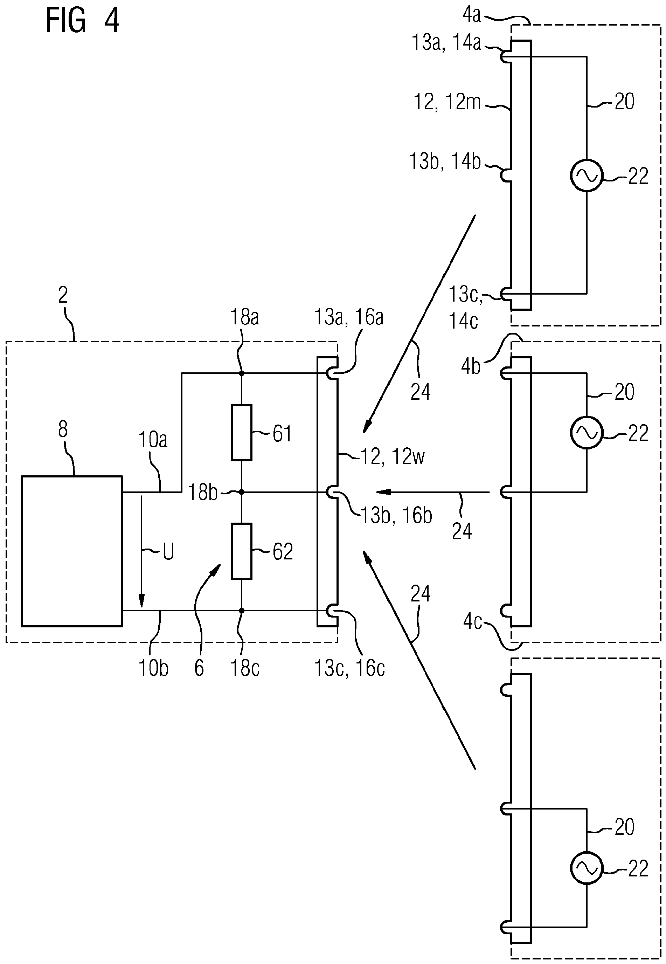

Fig. 4 zeigt eine erfindungsgemäße Baureihe von Strommessvorrichtungen 100, womit drei unterschiedliche Anschlusskombinationen einer Sekundärspule 20 und einer Reihenschaltung 6 von Bürden 61, 62 realisiert werden können. Die Strommessvorrichtungen 100 der Baureihe weisen jeweils eine identische Baugruppe 2, wie zu Fig. 1 beschrieben, und ein unterschiedliches Stromwandlermodul 4a, 4b, 4c, wie zu Fig. 1 bis 3 beschrieben, auf. Das bedeutet, dass eine Baugruppe 2 mit zwei oder mehr unterschiedlichen Stromwandlermodulen 4a, 4b, 4c verbindbar 24 ist. Die Verbindung 24 zwischen der Baugruppe 2 und dem Stromwandlermodul 4a, 4b, 4c erfolgt mittels eines mehrere Pole 13a, 13b, 13c aufweisenden Steckverbinders 12.

Zwei Strommessvorrichtungen 100 der Baureihe, jeweils eine Baugruppe 2 und ein unterschiedliches Stromwandlermodul 4a, 4b, 4c aufweisend, unterscheiden sich in mindestens einer Bürde 61, 62, die mit der Sekundärspule 20 zum Stromkreis geschaltet ist. So ist bei einem ersten Stromwandlermodul 4a die Sekundärspule 20 mit einem ersten Kontaktstift 14a und einem dritten Kontaktstift 14c, bei einem zweiten Stromwandlermodul 4b die Sekundärspule 20 mit einem ersten Kontaktstift 14a und einem zweiten Kontaktstift 14b, und bei einem dritten Stromwandlermodul 4a die Sekundärspule 20 mit einem zweiten Kontaktstift 14b und einem dritten Kontaktstift 14c verbunden. Entsprechend sind durch die Verwendung von identischen Baugruppen 2 mit einer identischen inneren Verschaltung der Reihenschaltung 6 bei a) einem Aufstecken 24 des ersten Stromwandlermoduls 4a auf die Baugruppe 2 beide Bürden 61, 62, b) einem Aufstecken 24 des zweiten Stromwandlermoduls 4b auf die Baugruppe 2 die erste Bürde 61, und c) einem Aufstecken des dritten Stromwandlermoduls 4c auf die Baugruppe 2 die zweite Bürde 62 in den Stromkreis geschaltet.

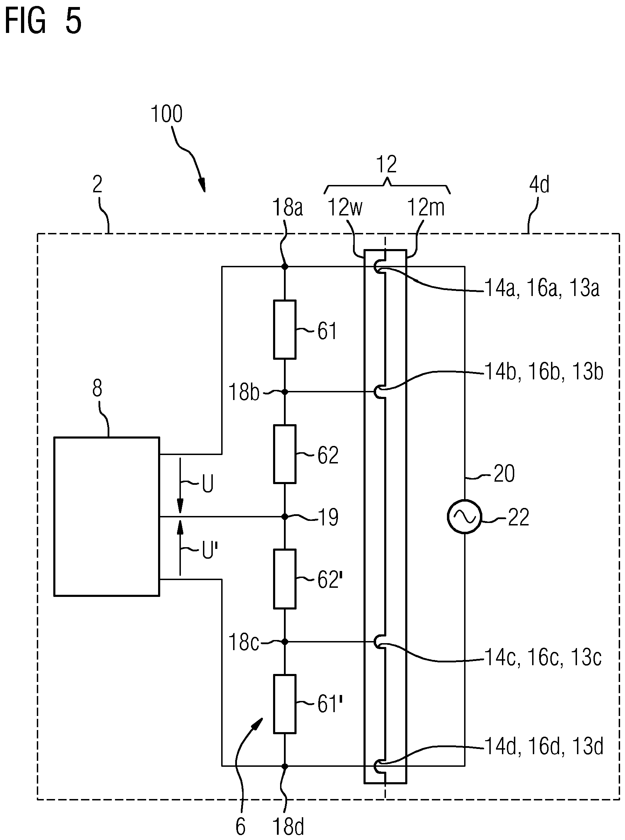

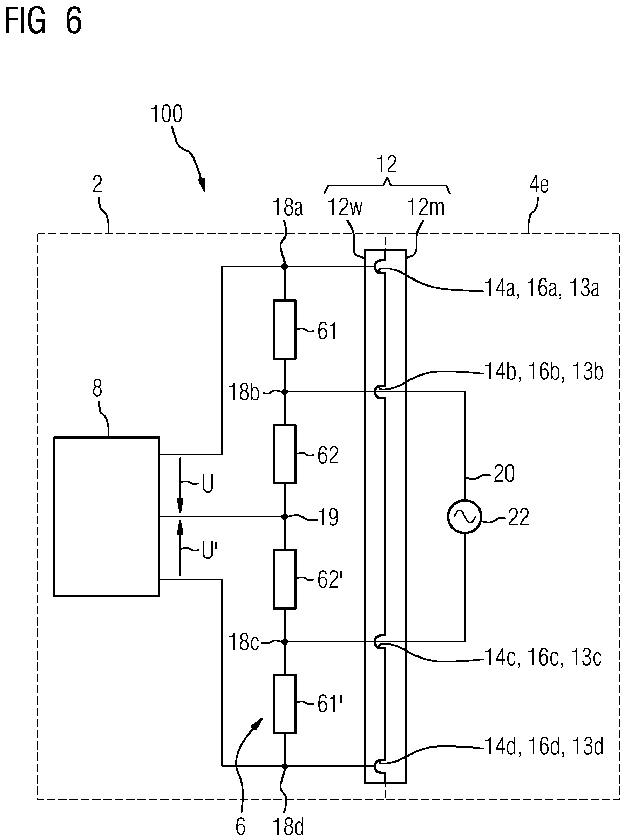

Fig. 5 und 6 zeigen zwei unterschiedliche Anschlusskombinationen einer Strommessvorrichtung 100 mit symmetrisch angeordneten Bürden.

Die Strommessvorrichtung 100 weist eine Baugruppe 2 mit vier Bürden 61, 61', 62, 62' in Reihenschaltung 6 auf. Die Reihenschaltung 6 umfasst eine erste Bürde 61 zwischen einer ersten Kontaktstelle 18a und einer zweiten Kontaktstelle 18b sowie eine zweite Bürde 62 zwischen der zweiten Kontaktstelle 18b und einem Symmetriepunkt 19. Die Reihenschaltung 6 umfasst außerdem eine zu der zweiten Bürde 62 identische dritte Bürde 62' zwischen dem Symmetriepunkt 19 und einer dritten Kontaktstelle 18c sowie eine zu der ersten Bürde 61 identische vierte Bürde 61' zwischen der dritten Kontaktstelle 18c und einer vierten Kontaktstelle 18d. Somit sind die Bürden 61, 61', 62, 62' der Reihenschaltung 6 in Bezug auf den Symmetriepunkt 19 symmetrisch angeordnet.

Die Strommessvorrichtung 100 weist ferner ein Stromwandlermodul 4d, 4e mit einer Sekundärspule 20 auf.

Die Strommessvorrichtung 100 weist außerdem einen vier Pole 13a, 13b, 13c, 13d aufweisenden Steckverbinder 12 auf, mithilfe dessen das Stromwandlermodul 4d, 4e mit der Baugruppe 2 lösbar verbunden ist. Die Pole 13a, 13b, 13c, 13d umfassen jeweils einen Kontaktstift 14a, 14b, 14c, 14d an einem männliche Teil 12m des Steckverbinders 12 und eine Kontaktöffnung 16a, 16b, 16c, 16d an einem weiblichen Teil 12w des Steckverbinders 12. Die vier Pole 13a, 13b, 13c, 13d umfassen zwei außenliegende Pole 13a, 13d und zwei innenliegende Pole 13b, 13c, wobei die zwei innenliegenden Pole 13b, 13c auf dem Steckverbinder 12 zwischen den zwei außenliegenden Polen 13a, 13d angeordnet sind.

Die ersten beiden Kontakte 18a, 18b und die letzten beiden Kontaktstellen 18c und 18d der Reihenschaltung 6 sind jeweils mit einer Kontaktöffnung 16a, 16b, 16c, 16d der vier Pole 13a, 13b, 13c, 13d des Steckverbinders 12 elektrisch leitend verbunden. Dabei ist die erste Kontaktstelle 18a mit einer Kontaktöffnung 16a des ersten außen liegenden Pols 13a, die zweite Kontaktstelle 18b mit der Kontaktöffnung 16b des ersten innenliegenden Pols 13b, die dritte Kontaktstelle 18c mit der Kontaktöffnung 16c des zweiten innen liegenden Pols 13c und die vierte Kontaktstelle 18d mit der Kontaktöffnung 16d des zweiten außen liegenden Pols 13d elektrisch verbunden.

Dabei ist in einer in Fig. 5 gezeigten ersten Anschlusskombination der Strommessvorrichtung 100 die Sekundärspule 20 des Stromwandlermoduls 4d mit den Kontaktstiften 14a, 14d der zwei außen liegenden Pole 13a, 13d des Steckverbinders 12 elektrisch leitend verbunden. Durch das Verbinden des männlichen Teils 12m des Steckverbinders 12 mit dem weiblichen Teil 12w des Steckverbinders 12 ist die Sekundärspule 20 mit der die vier Bürden 61, 62, 61', 62' umfassenden Reihenschaltung 6 elektrisch verbunden, so dass die Sekundärspule 20 und die vier Bürden 61, 62, 61', 62' einen Stromkreis bilden.

Somit kann ein durch einen zu messenden Primärstrom in der Sekundärspule 20 induzierter Sekundärstrom 22 durch diesen Stromkreis fließen. Eine über der ersten 61 und zweiten 62 Bürde des Stromkreises abfallende Spannung U wird abgegriffen, indem die erste Kontaktstelle 18a mit einem ersten Eingang einer Messwerterfassungseinheit 8 und der Symmetriepunkt 19 mit einem Bezugspotential-Eingang einer Messwerterfassungseinheit 8 verbunden wird. Eine über der dritten 62' und vierten 61' Bürde des Stromkreises abfallende Spannung U' wird abgegriffen, indem die vierte Kontaktstelle 18d mit einem zweiten Eingang der Messwerterfassungseinheit 8 verbunden und gegen das Potential des Bezugspotential-Eingangs gemessen wird. Es wird somit eine differentielle Spannungsmessung vorgenommen, bei der die Differenzspannung zwischen den symmetrisch angeordneten Hälften der Reihenschaltung 6 gemessen wird.

Demgegenüber ist in einer in Fig. 6 gezeigten zweiten Anschlusskombination der Strommessvorrichtung 100 die Sekundärspule 20 des in Fig. 6 gezeigten Stromwandlermoduls 4e mit den Kontaktstiften 14b, 14c der zwei innen liegenden Pole 13b, 13c des Steckverbinders 12 elektrisch leitend verbunden. Durch das Verbinden des männlichen Teils 12m des Steckverbinders 12 mit dem weiblichen Teil 12w des Steckverbinders 12 ist die Sekundärspule 20 mit den zwei im Mittelteil der Reihenschaltung 6 angeordneten Bürden 62, 62' elektrisch verbunden, so dass die Sekundärspule 20 und die zwei Bürden 62, 62' einen Stromkreis bilden.

In beiden Anschlusskombinationen kann somit kann ein durch einen zu messenden Primärstrom in der Sekundärspule 20 induzierter Sekundärstrom 22 durch den Stromkreis der Strommessvorrichtung 100 fließen. Die erste Kontaktstelle 18a ist mit einem ersten Eingang einer Messwerterfassungseinheit 8, die vierte Kontaktstelle 18e mit einem zweiten Eingang der Messwerterfassungseinheit 8 und der Symmetriepunkt 19 der Reihenschaltung 6 mit einem Bezugspotential-Eingang der Messwerterfassungseinheit 8 verbunden.

In der in Fig. 5 gezeigten Anschlusskombination der Strommessvorrichtung 100 wird eine differentielle Spannungsmessung vorgenommen, indem die über der ersten 61 und zweiten 62 Bürde des Stromkreises abfallende Spannung U und die über der dritten 62' und vierten 61' Bürde des Stromkreises abfallende Spannung U' gegen das Potential des Bezugspotential-Eingangs abgegriffen wird. Es wird somit eine differentielle Spannungsmessung vorgenommen, bei der die Differenzspannung zwischen den symmetrisch angeordneten Hälften der Reihenschaltung 6 gemessen wird. Aufgrund der Symmetrie der Bürden 61, 62, 61', 62' bezüglich des Symmetriepunkts 19 sollten die beiden Spannungswerte U und U' identisch sein.

In der in Fig. 6 gezeigten Anschlusskombination der Strommessvorrichtung 100 wird eine differentielle Spannungsmessung vorgenommen, indem die über der zweiten 62 Bürde des Stromkreises abfallende Spannung U und die über der dritten 62' Bürde des Stromkreises abfallende Spannung U' gegen das Potential des Bezugspotential-Eingangs abgegriffen wird. Es wird somit eine differentielle Spannungsmessung vorgenommen, bei der die Differenzspannung zwischen den symmetrisch angeordneten Bürden 62, 62' der Reihenschaltung 6 gemessen wird. Aufgrund der Symmetrie der Bürden 62, 62' bezüglich des Symmetriepunkts 19 sollten die beiden Spannungswerte U und U' identisch sein.

Je nach der Stromstärke des zu messenden Primärstroms wird die Anschlusskombination gemäß Fig. 5 mit vier in den Stromkreis geschalteten Bürden oder die Anschlusskombination gemäß Fig. 6 mit zwei in den Stromkreis geschalteten Bürden gewählt.

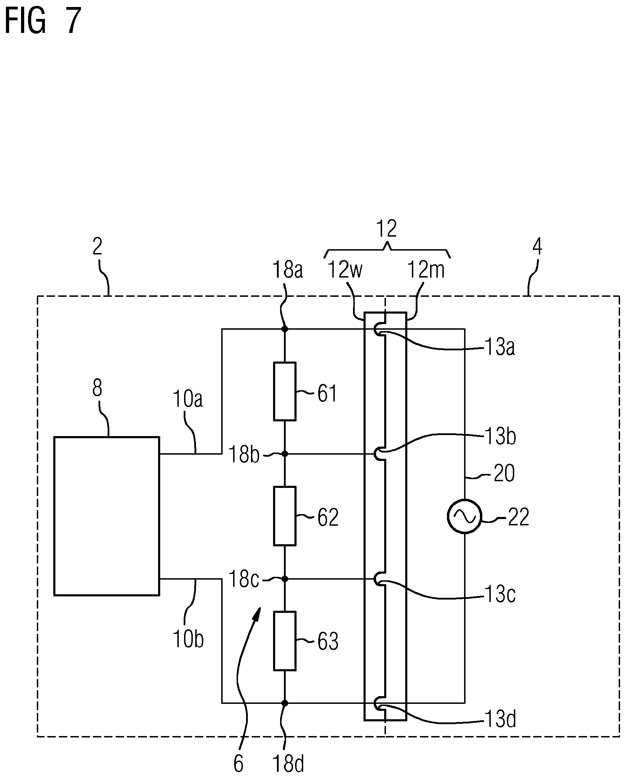

Fig. 7 zeigt eine Variante einer Strommessvorrichtung mit einer erweiterten Anzahl von drei Bürden 61, 62, 62, mit einem vier Pole 13a, 13b, 13c, 13d umfassenden Steckverbinder 12. Während in der in Fig. 4 gezeigten Baureihe in der Baugruppe 2 zwei Bürden 61, 62 in einer Reihenschaltung 6 angeordnet sind, mit einem drei Pole 13a, 13b, 13c umfassenden Steckverbinder 12, sind bei der in Fig. 7 gezeigten Baugruppe 2 drei Bürden 61, 62, 63 in einer Reihenschaltung 6 angeordnet, mit einem vier Pole 13a, 13b, 13c, 13d umfassenden Steckverbinder 12.

Gegenüber der in Fig. 4 gezeigten Baureihe, bei der drei Anschlusskombinationen der Sekundärspule 20 mit den zwei Bürden 61, 62 möglich sind, sind somit drei weitere Anschlusskombinationen einer Sekundärspule 20 mit den drei Bürden 61, 62, 63 möglich.

## Patentansprüche

1. Strommessvorrichtung (100), aufweisend

   - eine Baugruppe (2) mit zwei oder mehr Bürden (61, 62, 63) in Reihenschaltung (6) und
   - ein Stromwandlermodul (4, 4a, 4b, 4c) mit einer Sekundärspule (20),

wobei die Reihenschaltung (6) drei oder mehr Kontakte (18a, 18b, 18c, 18d) aufweist, so dass durch die Anschlusskombinationen der Sekundärspule (20) an jeweils zwei der drei oder mehr Kontakte (18a, 18b, 18c, 18d) verschiedene Gruppen von ein oder mehr Bürden (61, 62, 63) mit der Sekundärspule (20) zu einem Stromkreis geschaltet werden können, durch welchen ein durch einen zu messenden Primärstrom in der Sekundärspule (20) induzierter Sekundärstrom (22) fließen kann.

2. Strommessvorrichtung (100) nach Anspruch 1, aufweisend eine Messwerterfassungseinheit (8) mit Messkontakten (10a, 10b) zum Abgreifen einer über mindestens zwei der zwei oder mehr Bürden (61, 62, 63) abfallenden Spannung (U).

3. Strommessvorrichtung (100) nach einem der vorhergehenden Ansprüche, mit einem mehrere Pole (13a, 13b, 13c, 13d) aufweisenden Steckverbinder (12) zum Verbinden des Stromwandlermoduls (4, 4a, 4b, 4c) mit der Baugruppe (2).

4. Strommessvorrichtung (100) nach Anspruch 3, wobei die zwei oder mehr in Reihe (6) geschalteten Bürden (61, 62, 63) jeweils mit zwei Polen (13a, 13b, 13c, 13d) eines an der Baugruppe (2) angeordneten Teils (12w) des Steckverbinders (12) elektrisch leitend verbunden sind.

5. Strommessvorrichtung (100) nach einem der Ansprüche 3 und 4, wobei die Sekundärspule (20) des Stromwandlermoduls (4a, 4b, 4c) mit zwei Polen (13a, 13b, 13c, 13d) eines am Stromwandlermodul (4a, 4b, 4c) angeordneten Teils (12m) des mehrpoligen Steckverbinders (12) elektrisch leitend verbunden ist.

6. Strommessvorrichtung (100) nach einem der vorhergehenden Ansprüche, wobei die Reihenschaltung (6) zwei oder mehr Paare von Bürden (61, 62) mit gleichem elektrischen Widerstand aufweist, welche bezüglich eines Symmetriepunkts (19) der Reihenschaltung (6) symmetrisch angeordnet sind.

7. Baureihe von Strommessvorrichtungen (100) nach einem der vorhergehenden Ansprüche, wobei die Baugruppe (2) mit zwei oder mehr unterschiedlichen Stromwandlermodulen (4, 4a, 4b, 4c) verbindbar ist, und wobei zwei Strommessvorrichtungen (100) der Baureihe, jeweils die Baugruppe (2) und ein unterschiedliches Stromwandlermodul (4, 4a, 4b, 4c) aufweisend, sich in mindestens einer Bürde unterscheiden, die mit der Sekundärspule (20) zum Stromkreis geschaltet ist.

8. Verfahren zur Strommessung, mit folgenden Schritten:

- Bereitstellen einer Baugruppe (2) mit zwei oder mehr Bürden (61, 62, 63) in Reihenschaltung (6), wobei die Reihenschaltung (6) drei oder mehr Kontakte (18a, 18b, 18c, 18d) umfasst;
- Bereitstellen eines Stromwandlermoduls (4, 4a, 4b, 4c) mit einer Sekundärspule (20);
- Auswählen einer der möglichen Anschlusskombinationen (24), bei denen die Sekundärspule (20) mit jeweils zwei der drei oder mehr Kontakte (18a, 18b, 18c, 18d) so verbunden ist, dass mindestens eine der Bürden (61, 62, 63) mit der Sekundärspule (20) einen Stromkreis bildet;
- Verbinden (24) der Sekundärspule (20) mit zwei der drei oder mehr Kontakte (18a, 18b, 18c, 18d) gemäß der gewählten Anschlusskombination;
- Positionieren der Sekundärspule (20) so, dass durch einen zu messenden Primärstrom in der Sekundärspule (20) induzierter Sekundärstrom (22) durch den Stromkreis fließt;
- Abgreifen einer Spannung (U), welche über mindestens zwei der zwei oder mehr in Reihe (6) geschalteten Bürden (61, 62, 63) abfällt; und
- Berechnen eines Stromwerts des Primärstroms aus der gemessenen Spannung (U).

EP 3 489 696 A1

FIG 1

9

FIG 2

# FIG 3

# FIG 4

FIG 5

# FIG 6

FIG 7

**Europäisches Patentamt**
**European Patent Office**
**Office européen des brevets**

# EUROPÄISCHER RECHERCHENBERICHT

**Nummer der Anmeldung**

EP 18 20 3713

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | JP 2013 050385 A (PANASONIC CORP) 14. März 2013 (2013-03-14) <br> * Absatz [0042] - Absatz [0047] * <br> * Absatz [0063] - Absatz [0067] * <br> * Abbildung 1 * <br> * Abbildung 3 * <br> * Abbildung 4 * <br> * Abbildung 11 * <br> * Abbildung 13 * <br> ----- | 1-8 | INV. <br> G01R15/18 |
| X | JP 2001 208778 A (MATSUSHITA ELECTRIC WORKS LTD) 3. August 2001 (2001-08-03) <br> * Absatz [0015] - Absatz [0021] * <br> * Abbildung 1 * <br> * Abbildung 2 * <br> * Abbildung 3 * <br> * Abbildung 4 * <br> ----- | 1-8 | |
| A | EP 2 742 887 A1 (COVIDIEN LP [US]) 18. Juni 2014 (2014-06-18) <br> * das ganze Dokument * <br> ----- | 6 | **RECHERCHIERTE SACHGEBIETE (IPC)** <br><br> G01R |

Der vorliegende Recherchenbericht wurde für alle Patentansprüche erstellt

| Recherchenort | Abschlußdatum der Recherche | Prüfer |
|---|---|---|
| München | 15. April 2019 | Meliani, Chafik |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 18 20 3713

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-04-2019

| Im Recherchenbericht angeführtes Patentdokument | Datum der Veröffentlichung | Mitglied(er) der Patentfamilie | | Datum der Veröffentlichung |
|---|---|---|---|---|
| JP 2013050385 A | 14-03-2013 | CN | 103748475 A | 23-04-2014 |
| | | JP | 2013050385 A | 14-03-2013 |
| | | TW | 201323885 A | 16-06-2013 |
| | | WO | 2013030655 A1 | 07-03-2013 |
| JP 2001208778 A | 03-08-2001 | KEINE | | |
| EP 2742887 A1 | 18-06-2014 | AU | 2013273612 A1 | 03-07-2014 |
| | | CA | 2836453 A1 | 17-06-2014 |
| | | CN | 103869141 A | 18-06-2014 |
| | | CN | 203672944 U | 25-06-2014 |
| | | EP | 2742887 A1 | 18-06-2014 |
| | | US | 2014167740 A1 | 19-06-2014 |
| | | US | 2015331020 A1 | 19-11-2015 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006059384 A1
- WO 2012022377 A1
- DE 3541274 A1